Europäisches Patentamt

European Patent Office

Office européen des brevets

(19)

(11) Veröffentlichungsnummer: **0 399 202 B1**

(12) # EUROPÄISCHE PATENTSCHRIFT

(45) Veröffentlichungstag der Patentschrift: **23.03.94**

(51) Int. Cl.5: **H03H 7/48**, H03H 7/46

(21) Anmeldenummer: **90107179.5**

(22) Anmeldetag: **14.04.90**

(54) **Hochfrequenz-Richtkopplerabzweiger.**

(30) Priorität: **24.05.89 DE 3916855**

(43) Veröffentlichungstag der Anmeldung:
**28.11.90 Patentblatt 90/48**

(45) Bekanntmachung des Hinweises auf die
Patenterteilung:
**23.03.94 Patentblatt 94/12**

(84) Benannte Vertragsstaaten:
**AT CH DE DK ES FR IT LI NL SE**

(56) Entgegenhaltungen:
EP-A- 0 044 909
DE-A- 1 516 824
US-A- 3 766 499
US-A- 3 872 408

PATENT ABSTRACTS OF JAPAN, Band 13,
Nr. 333 (E-794)[3681], 26. Juli 1989 & JP-A-1
95 616

(73) Patentinhaber: **RICHARD HIRSCHMANN GMBH
& CO.**
**Postfach 110**
**D-73726 Esslingen(DE)**

(72) Erfinder: **Wendel, Wolfgang**
**Steinbruchstrasse 62**
**D-7316 Köngen(DE)**
Erfinder: **Epple, Ralf**
**Lessingstrasse 17**
**D-7314 Wernau(DE)**
Erfinder: **Stadler, Heinz**
**Weikersheimer Strasse 17**
**D-7000 Stuttgart 40(DE)**

(74) Vertreter: **Stadler, Heinz, Dipl.-Ing.**
**Richard Hirschmann GmbH & Co.,**
**Postfach 1 10**
**D-73726 Esslingen (DE)**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung betrifft einen Hochfrequenz-Richtkopplerabzweiger gemäß dem Oberbegriff des Anspruches 1. Derartige Abzweiger werden beispielsweise in Gemeinschafts- und Kabelfernsehanlagen dazu benutzt, Signale mit bestimmten Dämpfungen aus einer Stammleitung auf weiterführende Leitungen, Verteileinrichtungen oder auch direkt auf Antennenanschlußdosen auszukoppeln.

Eine Richtkopplerabzweiger der eingangs genannten Art ist beispielsweise aus den Figuren 1 und 2 (Typ A) der DE 30 28 683 C2 (EP-A-0044909) bekannt, wobei dort der Strom-und der Spannungsübertrager das gleiche Windungszahlenverhältnis n aufweisen. Er ist breitbandig bis 860 MHz mit guter Anpassung und hoher Entkopplung von Ausgang und Abzweig für Abzweigdämpfungen von etwa 12 bis 16 dB realisierbar. Insbesondere an Anfang längerer Stammleitungen ohne Verstärker werden jedoch Abzweiger mit Abzweigdämpfungen von mehr als 16 dB benötigt, damit durch die so erzielte geringere Stammbelastung eine ausreichende Versorgung der Teilnehmer mit Hochfrequenzenergie auch am Ende der Stammleitung noch gewährleistet ist. Dazu sind für die Sekundärwicklung des Strom- sowie die Primärwicklung des Spannungsübertragers jeweils mehr als 4 Windungen nötig, deren große Streuinduktivität aber eine Verringerung der oberen Grenzfrequenz bezüglich Entkopplung, Anpassung und Durchgangsdämpfung bedingt. Damit sind die Einsatzmöglichkeiten, besonders im Hinblick auf den heute immer häufiger in den genannten Verteilnetzen zu übertragenden ersten Satelliten-Zwischenfrequenzbereich (0,95 bis 1.75 GHz) stark eingeschränkt.

Die andere Möglichkeit zur Erzielung der erforderlichen hohen Abzweigdämpfung, nämlich die Verwendung zum Beispiel eines 14 dB-Richtkopplerabzweigers mit nachgeschaltetem Dämpfungsglied (z.B. $\pi$-Glied) ist zwar breitbandig mit relativ hoher oberer Grenzfrequenz herstellbar, erfordert jedoch einen insbesondere bei Massenartikeln wie Antennensteckdosen häufig untragbar hohen Schaltungsaufwand und weist trotz der großen Gesamtabzweigdämpfung eine zu hohe Durchgangsdämpfung auf.

Der Erfindung liegt daher die Aufgabe zugrunde, einen Richtkopplerabzweiger der eingangs genannten Art mit möglichst geringem Schaltungsaufwand derart weiterzubilden, daß er breitbandig mit einer oberen Grenzfrequenz von 1,75 GHz bei geringer Durchgangsdämpfung, hoher Entkopplung und guter Anpassung aller Anschlüsse Abzweigdämpfungen von ≥ 16 dB ermöglicht.

Diese Aufgabe ist erfindungsgemäß durch die kennzeichnenden Merkmale des Anspruches 1 gelöst.

Ausgehend von einem wegen der hohen oberen Grenzfrequenz möglichst geringen Windungszahlenverhältnis n der Übertrager von maximal 4, wobei n aus Gründen des praktischen Aufbaus stets ganzzahlig ist und hier immer das Verhältnis der größeren zur kleiner Windungszahl angibt (n > 1), ist mit äußerst geringem Aufwand, nämlich nur einem einzigen zusätzlichen ohmschen Widerstand, bereits eine Abzweigdämpfung bis zu 20 dB bei einer Abzweigimpedanz ≤ ein Viertel des Wellenwiderstandes (z.B. mittels dreier nachgeschalteter Differentialübertrager gebildeter Vierfach-Abzweiger) oder 17 dB bei einer Abzweigimpedanz ≤ dem halben Wellenwiderstand (zum Beispiel Zweifach-Abzweiger als Antennensteckdose) erreichbar. Die Durchgangsdämpfung liegt dabei, insbesondere durch den induktivitätsarmen Anschluß des Parallelwiderstandes zum Beispiel in SMD-Technik, mit Sicherheit breitbandig unter 1 dB.

Die genannten Vorteile sind überdies durch den Parallelwiderstand weitgehend unabhängig von Fehlanpassungen des Abzweiganschlusses, wie sie beispielsweise bei Antennensteckdosen häufig vorkommen, wenn der Stecker des Empfängeranschlußkabels nicht eingesteckt ist. Ohne den Parallelwiderstand würde sich ein solcher Leerlauf über den Stromübertrager auf die Stammleitung transformieren und deren Durchgangsdämpfung erhöhen.

Für größere Impedanzen des Abzweiganschlusses (zum Beispiel gleich dem Wellenwiderstand $Z_L$ bei einem Einfachabzweiger oder dem halben Wellenwiderstand bei einem aus einem Einfachabzweiger mit nachgeschaltetem Differentialübertrager aufgebauten Zweifachabzweiger) und noch höheren Abzweigdämpfungen ist eine Ausgestaltung der Erfindung gemäß Anspruch 2 vorteilhaft. Durch Einschaltung lediglich eines weiteren ohmschen Widerstandes ist dabei außerdem ein zusätzlicher Freiheitsgrad für die paxisgerechte Auswahl der Übertrager-Übersetzungsverhältnisse und der Werte der drei Widerstände erreicht.

Bei einer Ausführung des Richtkoppler-Abzweigers nach Anspruch 1 ergibt sich durch die Festlegung der gewünschten Abzweigdämpfung und -impedanz lediglich ein einziger Wert für das Windungszahlenverhältnis des Stromübertragers, der in der Regel zwischen zwei ganzen Zahlen liegt. Da aber, wie bereits ausgeführt, nur ganzzahlige Werte für die Windungszahlenverhältnisse möglich sind, weicht in diesem Fall die Anpassung am Abzweig vom Idealwert ab. Bei einer Ausbildung des erfindungsgemäßen Richtkopplerabzweigers nach Anspruch 2 ist demgegenüber durch entsprechende Wahl des weiteren ohmschen Widerstands auf äußerst einfache Weise das Windungszahlenverhältnis des Stromübertragers ohne Abweichung vom Sollwert der Impedanz des Abzweiganschlusses ganzzahlig. Insgesamt ist mit dieser Ausführung ein Richtkopplerabzweiger geschaffen, der im gesamten Frequenzbereich von ca. 4 MHz bis 1,75 GHz über einen weiten Bereich hoher Abzweigdämpfungen (ab ca. 16 dB) eine geringe Durchgangsdämpfung sowie eine hohe Entkopplung von Ausgang und Abzweiganschluß bei zugleich guter Anpassung an allen Anschlüssen aufweist.

In aller Regel sind bei der Entwicklung eines Richtkopplerabzweigers, wie bereits angeführt, die Werte für die Abzweigimpedanz und die Abzweigdämpfung entsprechend den Bedürfnissen des jeweiligen Anwendungsfalles vorgegeben. Daraus leiten sich folgende Größen als Funktion des weiteren ohmschen Widerstandes wie folgt ab:

$$n_2 = \frac{2 \cdot 10^{-\frac{a_{AB}}{20}}}{1 + \frac{Z_L}{Z_{AB} - R_S}}$$

$$n_1 \le n_2 \cdot \frac{\frac{Z_L}{Z_{AB} - R_S} - \frac{R_S}{Z_L}}{1 + \frac{R_S}{Z_L}}$$

$$R_P = \frac{n_2 \cdot Z_L}{\frac{2 \cdot 10^{-\frac{a_{AB}}{20}}}{1 + \frac{R_S}{Z_L}} - n_1 - n_2}$$

$$R = \frac{n_1 n_2 - 1}{n_1^2} \cdot Z_L$$

$$a_D = 20 \lg \frac{2(n_1 n_2 - 1)}{2 n_1 n_2 - 1} ,$$

wobei

$n_2$    das Verhältnis der größeren zur kleineren Windungszahl des Stromübertragers,

$n_1$    das Verhältnis der größeren zur kleineren Windungszahl des Spannungsübertragers,

$R_P$    der parallel zur Sekundärwicklung des Stromübertragers eingeschaltete ohmsche Widerstand,

$R_s$    der zwischen dem Verbindungspunkt der Sekundärwicklungen der beiden Übertrager und dem abzweiganschluß eingeschaltete weitere ohmsche Widerstand,

$R$    der zwischen der Sekundärwicklung des Spannungsübertragers und Masse eingeschaltete interne Abschlußwiderstand

$a_{AB}$    die Abzweigdämpfung,

$a_D$    die Durchgangsdämpfung und

$Z_L$    der Wellenwiderstand der angeschlossenen Leitungen ist.

Durch eine den praktischen Erfordernissen angepaßte Festlegung von Durchgangsdämpfung (zum Beispiel ≤ 1 dB) und $n_2$ (zum Beispiel 2, 3 oder 4) läßt sich sehr einfach der mögliche Bereich des Widerstandes $R_s$ und des Windungszahlenverhältnisses $n_1$ und damit auch der Widerstände $R$ und $R_p$ bestimmen. Dazu werden zweckmäßigerweise die Funktionen $n_2 = f(R_s)$ sowie $a_D = f(R_s)$ mit $n_1$ als Parameter aufgetragen und die vorgesehenen Grenzen für $a_D$ und $n_2$ markiert. Daraus sind dann sofort die möglichen Werte für $n_1$ (dessen Höchstwert praktisch nicht durch den errechneten Höchstwert, sondern im Hinblick auf die zu erreichende obere Grenzfrequenz als Erfahrungswert vorgegeben ist) und die zugehörigen Werte für $R_s$ ablesbar. Die Werte für $R$ und $R_p$ sind daraus entweder nach der angegebenen Formel zu errechnen oder aus einer Kurvenschar $R_p = f(R_s)$ mit Parameter $n_1$ bzw. $R = f(n_2)$ mit Parameter $n_1$ zu ersehen.

Gemäß einer weiteren vorteilhaften Ausgestaltung der Erfindung besteht der interne Abschlußwiderstand $R$ aus je einem in Reihe zur Primär- und zur Sekundärwicklung des Spannungsübertragers geschalteten ohmschen Widerstand $R_1$ und $R_2$. Es ist also ein Teil des an sich in Reihe zur Sekundärwicklung eingeschalteten gesamten internen Abschlußwiderstandes $R$ auf die Primärseite des Spannungsübertragers transformiert. Der in Serie zur Primärwicklung liegende Widerstand $R_1$ ist dabei ≤ $n_1 \cdot Z_L$, also beispielsweise ≤ 225 Ω bei einem Übersetzungsverhältnis $n_1$ = 3 und einem Wellenwiderstand $Z_L$ = 75 Ω. Der in Serie zur Sekundärwicklung des Spannungsübertragers liegende Widerstand $R_2$ bestimmt sich daraus durch die Formel

$$R_2 = \left( \frac{n_2}{n_1} - \frac{1}{n_1^2} \right) \cdot Z_L - \frac{R_1}{n_1^2}$$

und würde mit obigen Werten für $n_1$ und $Z_L$ sowie $n_2 = 3$ zwischen 42 und 67 Ω liegen.

Durch diese Aufteilung des internen Richtkoppler-Abschlußwiderstandes ist mit geringem Aufwand bei tiefen Frequenzen sowohl eine Reduzierung der Durchgangsdämpfung als auch eine Erhöhung der Rückflußdämpfung am Ein- und Ausgang erreicht.

Eine weitere vorteilhafte Ausgestaltung des erfindungsgemäßen Richtkopplerabzweigers ist in Anspruch 4 angegeben. Dieser Aufbau, bei dem die x Teilwicklungen jeweils in einem Winkelbereich von 360 : x Grad auf dem Rohrkern angeordnet sind, ist zwar etwas Aufwendiger in der Herstellung, ergibt aber eine nochmalige deutliche Senkung der Durchgangsdämpfung bei höheren Frequenzen ab dem UHF-Bereich, wodurch zum Beispiel bei einer Ausbildung gemäß Anspruch 1 (ohne $R_s$) eine Abzweigdämpfung von 20 dB auch noch bei einer Abzweigimpedanz von 0,5 · $Z_L$ erreichbar ist oder bei einer solchen nach Anspruch 2 eine Durchgangsdämpfung ≤ 0,5 dB bis 1,75 GHz.

Der erfindungsgemäße Richtkopplerabzweiger kann selbstverständlich nicht nur für sich alleine sondern auch als Bauteil von Mehrfach-Abzweigeinrichtungen verwendet werden, zum Beispiel in einer solchen nach der bereits genannten DE 30 28 683 C2 mit alternierend zusammengeschalteten, die Eingangsimpedanz abwechselnd zu niedrigeren (Typ A) und zu höheren Werten (Typ B) transformierenden Einzelabzweigern, wobei der erfindungsgemäße Abzweiger zum Typ A gehört.

Die Erfindung wird nachstehend anhand eines Ausführungsbeispiels erläutert. Es zeigen:

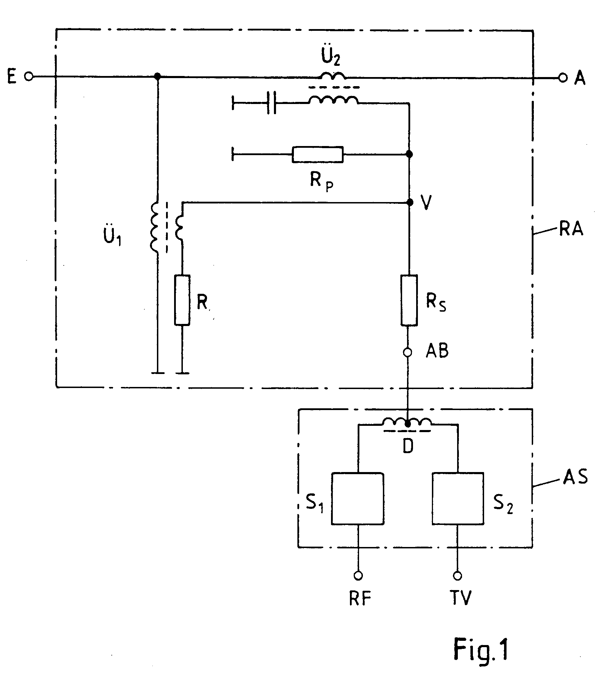

Figur 1    ein Prinzipschaltbild des erfindungsgemäßen Hochfrequenz-Richtkopplerabzweigers in einer Anwendung als Antennensteckdose,

Figur 2    eine graphische Darstellung der Funktionen $n_{1max}$ und $n_2 = f(R_s)$, sowie der Kurvenschar $a_D = f(R_s)$ mit $n_1$ als Parameter und

Figur 3    eine graphische Darstellung der Funktionen R und $R_p = f(n_2)$ mit $n_1$ als Parameter.

Die Antennensteckdosenschaltung besteht aus einem Einfach-Richtkopplerabzweiger RA und einer Auftrennschaltung AS. Der Richtkopplerabzweiger RA weist einen Spannungsübertrager $Ü_1$, einen Stromübertrager $Ü_2$, einen in Reihe zur Sekundärwicklung des Spannungsübertragers $Ü_1$ liegenden internen Abschlußwiderstand R zur Gewährleistung der hohen (theoretisch unendlich großen) Entkopplung der Richtkopplerschaltung, einen parallel zur Sekundärwicklung des Stromübertragers induktivitätsarm nach Art einer SMD-Verbindung mit dieser verbundenen Parallelwiderstand $R_p$ sowie einen zwischen dem Verbindungspunkt V der Sekundärwicklungen der beiden Übertrager $Ü_1$, $Ü_2$ und dem Abzweiganschluß AB eingeschalteten Serienwiderstand $R_s$ auf.

Die Auftrennschaltung AS besteht aus einem als Zweifach-Verteiler wirkenden Differentialübertrager D, der eingangsseitig mit dem Abzweiganschluß AB und mit seinen beiden Ausgängen über je ein Selektionsmittel $S_1$ und $S_2$ zum Ausfiltern des Tonrundfunk- bzw. des Fernsehsignals aus dem am Abzweiganschluß AB zur Verfügung stehenden Breitbandsignal mit den zugehörigen Steckdosenausgängen RF und TV verbunden ist. Die Impedanz am Abzweiganschluß AB beträgt für optimale Anpassung $0,5Z_L = 37,5$ Ω.

Die Hauptleitung des Richtkopplers zwischen dem Eingang E und dem Ausgang A des Richtkopplerabzweigers RA liegt im Zuge einer längeren Gemeinschaftsanlagen-Stammleitung an deren Anfang. Es ist bekannt, die Abzweigdämpfung von in einer Stammleitung liegenden Abzweigern vom Beginn zum Ende der Stammleitung hin abgestuft zu verringern, damit alle Teilnehmer nur die erforderliche Hochfrequenzleistung erhalten und somit die zur Verfügung stehende gesamte Hochfrequenzleistung optimal ausgenutzt ist. Im vorliegenden Anwendungsfall ist aus diesem Grunde eine relativ hohe Abzweigdämpfung von 20 dB vorgesehen, wobei an den Dosenanschlüssen RF und TV ein um ca. 24 dB gedämpftes Signal zur Verfügung steht, welches um einen Sicherheitsbetrag über den minimal erforderlichen Empfängereingangspegel liegt.

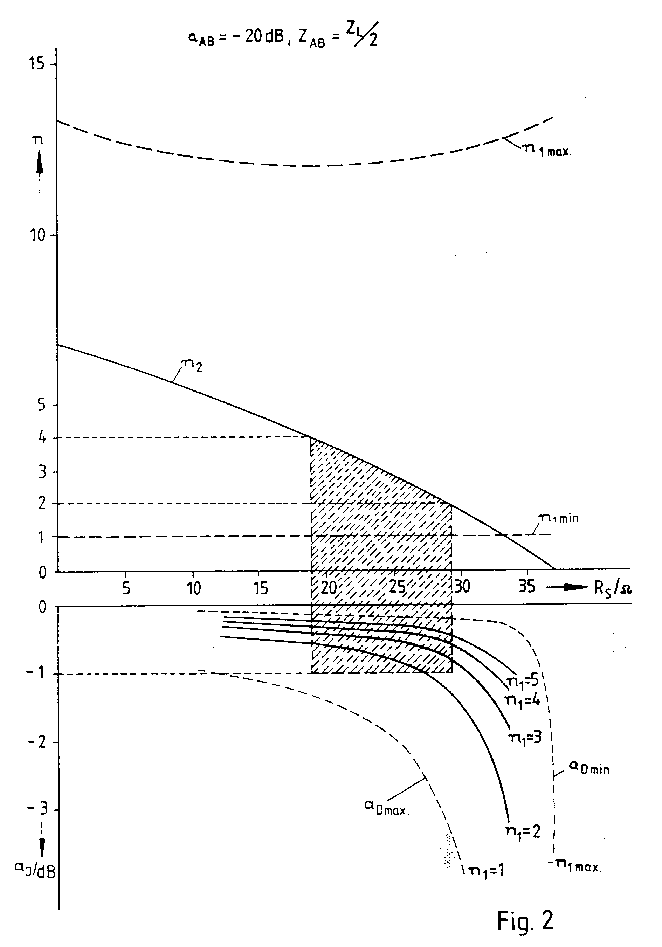

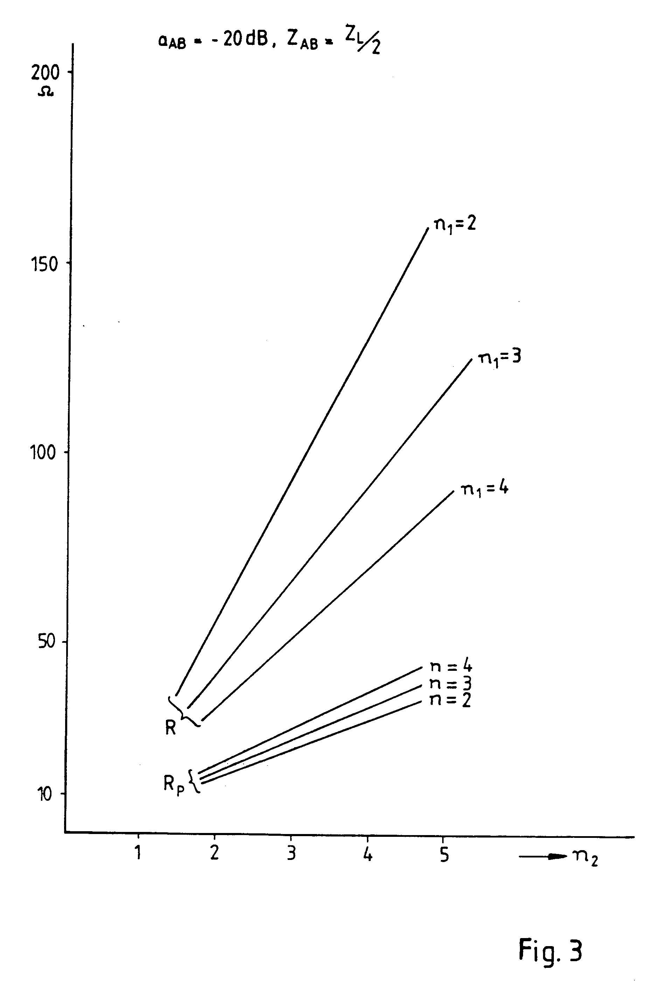

Aus den genannten Werten für $Z_{AB}$ und $a_{AB}$ sind mit Hilfe der bereits angeführten Formeln die Werte für $n_{1max}$, $n_2$ und damit $a_D$, R und $R_p$ berechnet und als Kurven bzw. Kurvenscharen in den Figuren 2 und 3 abgebildet. Im Hinblick auf die genannte hohe obere Grenzfrequenz dürfen erfahrungsgemäß die Windungszahlenverhältnisse $n_1$ und $n_2$ den Wert 4 nicht übersteigen, so daß aus dieser Sicht nur $n_{1,2}$ = 2, 3, 4 in Betracht kommt; weiterhin soll die Durchgangsdämpfung $a_D ≤ 1$ dB sein. Mit diesen Grenzen ergibt sich für die Bemessung der in Figur 2 schraffierte Bereich. Da wie gesagt n nur ganzzahlig sein kann, ergeben sich folgende Alternativen:

1.

    a) $n_1$ = 3; $n_2$ = 2

    b) $n_1$ = 2; $n_2$ = 3.

    In beiden Fällen ist $a_D ≤ 0,8$ dB.

2. $n_1$ = $n_2$ = 3. Dabei ist $a_D ≤ 0,5$ dB.

Die Größen der zugehörigen Widerstände $R_s$ bzw. $R_p$ und R ergeben sich aus den zugehörigen Diagrammen in den Figuren 2 bzw. 3 zu:

1.

    a) $R_s$ ≈ 29 Ω; $R_p$ ≈ 16 Ω; R ≈ 42 Ω.

    b) $R_s$ ≈ 24 Ω; $R_p$ ≈ 22 Ω; R ≈ 94 Ω.

2. $R_s$ ≈ 24 Ω; $R_p$ ≈ 25 Ω; R ≈ 67 Ω.

Aus diesen Alternativen ist für das tatsächliche praktische Ausführungsbeispiel der Fall 2 ausgewählt. Dabei ist die Sekundärwicklung des auf einen Rohrkern gewickelten Stromübertragers $Ü_2$ - (die Primärwicklung besteht nur aus einem durch die Kernbohrung geführten Draht, der einer Windung entspricht) anstatt aus drei Einzelwindungen aus 3 x 3 einander parallel geschalteten und am Umfang des Rohrkerns gleichmäßig verteilten Windungen aufgebaut. Dadurch ist die Streuinduktivität dieses Übertragers wesentlich verringert und die obere Grenzfrequenz noch einmal angehoben, so daß insgesamt die Antennensteckdose im Frequenzbereich von ca. 4 MHz bis 1,75 GHz eine Durchgangsdämpfung von maximal 0,5 dB aufweist.

Wie bereits ausgeführt, ist es auch möglich, zur Verbesserung der Durchgangsdämpfung und der Rückflußdämpfungen am Ein- und Ausgang bei tiefen Frequenzen den internen Abschlußwiderstand R gemäß Anspruch 3 aufzuteilen. Die Widerstände $R_1$ und $R_2$ lassen sich aus den in dieser Ausführung genannten Formeln einfach berechnen. Beispielsweise ergeben sich danach für die o.g. zweite Alternative folgende Werte:

$R_1 \leq 225\ \Omega$ und $42\ \Omega \leq R_2 \leq 67\ \Omega$.

Die angeführten Bauteilebemessungen (hauptsächlich die Widerstandswerte) lassen sich selbstverständlich in der Praxis nicht immer absolut genau realisieren, so daß sich für die Dämpfungen und Anschlußimpedanzen geringfügige Abweichungen von den optimalen Werten ergeben. Durch die erfindungsgemäße Schaltung ist es aber auf sehr einfache und kostengünstige Weise möglich, Richtkopplerabzweiger bis zu sehr hohen Frequenzen mit hoher Abzweigdämpfung bei guter Entkopplung sowie hohen Rückflußdämpfungen an allen Anschlüssen herzustellen. Damit sind auch bei Übertragung des ersten Satelliten-Zwischenfrequenzbereichs in Gemeinschaftsantennenanlagen längere Stammleitungen ohne Verstärker und damit erhebliche Einsparungen ermöglicht.

## Patentansprüche

1. Hochfrequenz-Richtkopplerabzweiger mit einem Spannungs-(Ü1) und einem Stromübertrager (Ü2) sowie einem internen Abschlußwiderstand (R), wobei der Verbindungspunkt der Sekundärwicklungen der beiden Übertrager (Ü1, Ü2) den Abzweig bildet und der interne Abschlußwiderstand zwischen der Sekundärwicklung des Spannungsübertragers und Masse eingeschaltet ist,
dadurch gekennzeichnet, daß zur Erhöhung der Abzweigdämpfung ein zur Sekundärwicklung des Stromübertragers (Ü2) parallelgeschalteter, mit dieser induktivitätsarm verbundener ohmscher Widerstand ($R_p$) vorgesehen ist und dieser Widerstand ($R_p$) sowie die Übersetzungsverhältnisse ($n_1$, $n_2$) der beiden Übertrager (Ü1, Ü2) so gewählt sind, daß sich am Abzweiganschluß (AB) möglichst genau die Sollwerte für die Abzweigdämpfung und -impedanz ergeben.

2. Hochfrequenz-Richtkopplerabzweiger nach Anspruch 1, dadurch gekennzeichnet, daß zwischen dem Verbindungspunkt (V) der Sekundärwicklungen der beiden Übertrager (Ü1, Ü2) und dem Abzweiganschluß (AB) ein weiterer

ohmscher Widerstand ($R_s$) eingeschaltet ist, dessen Wert so gewählt ist, daß die Übersetzungsverhältnisse ($n_1$, $n_2$) der Übertragerwicklungen und die Durchgangsdämpfung möglichst klein sind.

3. Hochfrequenz-Richtkopplerabzweiger nach Anspruch 1 oder 2, dadurch gekennzeichnet, daß der interne Abschlußwiderstand (R) aus jeweils einem in Reihe zur Primär- und zur Sekundärwicklung des Spannungsübertragers (Ü1) geschalteten ohmschen Widerstand ($R_1$, $R_2$) besteht, wobei der Wert des in Reihe zur Primärwicklung des Spannungsübertragers (Ü1) geschalteten Widerstandes ($R_1$) höchstens so groß ist wie das Produkt aus dem Übersetzungsverhältnis $n_1$ des Spannungsübertragers (Ü1) und dem Wellenwiderstand ($Z_L$) der angeschlossenen Leitungen.

4. Hochfrequenz-Richtkopplerabzweiger nach einem der Ansprüche 1 bis 3, dadurch gekennzeichnet, daß der Stromübertrager (Ü2) einen Rohrkern aufweist und seine Sekundärwicklung aus wenigstens zwei parallelgeschalteten Teilwicklungen besteht, die auf dem Rohrkern gleichmäßig am Umfang verteilt angeordnet sind.

## Claims

1. High frequency branching directional coupler with one voltage transmitter (Ü1) and one current transmitter (Ü2) as well as one internal termination resistance (R) wherewith the point of interconnection of the secondary windings of the two transmitters (Ü1, Ü2) forms the bifurcating connection point and the internal termination resistance is connected between the secondary windings of the voltage transmitter and ground,
in such a way characterized, that for the purpose of increasing the attenuation of the bifurcation, an ohmic resistance ($R_p$) is provided that is switched in parallel and connected with low inductance to the secondary windings of the current transmitter (Ü2), this resistance ($R_p$) as well as the transmission ratios ($n_1$, $n_2$) of the transmitter windings of the two transmitters (Ü1, Ü2) being chosen in such a way that as a result, at the bifurcating connection point (AB) the intended values for the bifurcation attenuation and impedance are obtained as exactly as possible.

2. High frequency branching directional coupler according to claim 1, in such a way characterized, that between the connection point (V) of the secondary windings of the two transmitters ($\ddot{U}_1$, $\ddot{U}_2$) and the bifurcating connection point (AB) another ohmic resistance ($R_s$) is provided whose value is chosen in such a way that the transmission ratios ($n_1$, $n_2$) of the transmitter windings and the pass-through attenuation are as small as possible.

3. High frequency branching directional coupler according to either claim 1 or claim 2, in such a way characterized, that the internal termination resistance (R) consists of one ohmic resistance each ($R_1$, $R_2$), being connected in series to the primary and the secondary windings of the voltage transmitter ($\ddot{U}_1$), wherewith the value of the resistance ($R_1$) being connected in series to the primary windings of the voltage transmitter ($\ddot{U}_1$) is as a maximum as large as the product of the transmission ratio ($n_1$) of the voltage transmitter ($\ddot{U}_1$) and the iterative wave resistance ($Z_L$) of the connected lines.

4. High frequency branching directional coupler according to one of the claims 1 to 3, in such a way characterized, that the current transmitter ($\ddot{U}_2$) possesses a pipe-core and that its secondary windings consist of at least two partial windings connected in parallel that are evenly placed on the circumference of the pipecore.

**Revendications**

1. Coupleur directionnel de dérivation à hautes fréquences avec un translateur de tension ($\ddot{U}_1$) et un translateur de courant ($\ddot{U}_2$) et avec une résistance terminale interne (R), où le point de connexion entre les enroulements secondaires des deux translateurs ($\ddot{U}_1$, $\ddot{U}_2$) forme le branchement et la résistance terminale interne (R) est connectée entre les enroulements secondaires du translateur de tension et terre, caractérisé par les faits qu'une résistance ohmique ($R_p$) est prévue pour augmenter l'atténuation de branchement qui est connectée avec petite inductance en parallèle aux enroulements secondaires du translateur de courant ($\ddot{U}_2$), et que cette résistance ($R_p$) et les relations de transmission ($n_1$, $n_2$) des deux translateurs ($\ddot{U}_1$, $\ddot{U}_2$) sont choisi ainsi qu'au point de branchement (AB), les valeurs prescrites pour l'atténuation de branchement et l'impédance sont obtenues si exactement que possible.

2. Coupleur directionnel de dérivation à hautes fréquences comme en revendication 1, caractérisé par les faits qu'entre le point de connexion (V) des enroulements secondaires des deux translateurs ($\ddot{U}_1$, $\ddot{U}_2$) et le point de branchement (AB), une autre résistance ohmique ($R_s$) est introduite la valeur de qui est choisi ainsi que les relations de transmission ($n_1$, $n_2$) des enroulements des translateurs et l'atténuation de passage sont si petites que possible.

3. Coupleur directionnel de dérivation à hautes fréquences comme en revendication 1 ou 2, caractérisé par les faits que la résistance terminale interne (R) se compose d'une résistance ohmique ($R_1$, $R_2$) chaque, qui sont connectées en série avec les enroulements primaires et secondaires du translateur de tension ($\ddot{U}_1$) dont la résistance ($R_1$) connectée en série avec les enroulements primaires du translateur de tension ($\ddot{U}_1$) a une valeur maximum correspondante au produit de la relation de transmission ($n_1$) du translateur de tension ($\ddot{U}_1$) et la résistance itérative ($Z_L$) des lignes interconnectées.

4. Coupleur directionnel de dérivation à hautes fréquences comme selon une des revendications 1 à 3, caractérisé par les faits que le translateur de courant ($\ddot{U}_2$) a un noyau tubulaire et que ses enroulements secondaires se composent de deux enroulements partiels connectés en parallèle qui sont uniformément réparti sur la périphérie du noyau tubulaire.

Fig.1

$a_{AB} = -20\,dB$, $Z_{AB} = Z_L/2$

Fig. 2

Fig. 3